# EUROPEAN PATENT SPECIFICATION

(11) **EP 4 228 012 B1**
(45) Date of publication and mention of the grant of the patent: **25.09.2024**
(21) Application number: 22461577.3
(22) Date of filing: 23.06.2022
(51) Int. Cl.: H01L 33/00, H01L 33/02, H01L 33/06, H01L 33/32, H01L 33/14

(54) **WAVELENGTH TUNABLE LIGHT EMITTING DIODE AND METHOD OF MAKING THE SAME**
WELLENLÄNGENABSTIMMBARE LEUCHTDIODE UND VERFAHREN ZUR HERSTELLUNG DERSELBEN
DIODE ÉLECTROLUMINESCENTE À LONGUEUR D'ONDE ACCORDABLE ET SON PROCÉDÉ DE FABRICATION

(30) Priority: 12.02.2022 PL 44037522
(43) Date of publication of application: 16.08.2023
(73) Proprietor: Instytut Wysokich Cisnien Polskiej Akademii Nauk, 01-142 Warszawa (PL)
(72) Inventor: ZAK, Mikolaj, 66-110 Babimost (PL); TURSKI, Henryk, 02-555 Warszawa (PL); CHLIPALA, Mikolaj, 84-200 Wejherowo (PL); NOWAKOWSKI-SZKUDLAREK, Krzesimir, 01-710 Warszawa (PL); MUZIOL, Grzegorz, 01-466 Warszawa (PL); HAJDEL, Mateusz, 81-173 Gdynia (PL); WOLNY, Pawel, 42-700 Lubliniec (PL); SKIERBISZEWSKI, Czeslaw, 05-502 Kamionka (PL)
(74) Representative: AOMB Polska Sp. z.o.o.

(56) References cited:
- WO-A1-2008/030183
- JP-A- 2002 237 619
- US-B2- 10 418 516
- LEE KWANJAE ET AL: "Flower-like light distribution inside InGaN-based light-emitting diodes operated in spectral range from violet to red", 2017 75TH ANNUAL DEVICE RESEARCH CONFERENCE (DRC), IEEE, 25 June 2017 (2017-06-25), pages 1 - 2, XP033135341, DOI: 10.1109/DRC.2017.7999457

## Description

The present invention relates to a wavelength tunable light emitting diode and a method of fabrication of such diode.

Conventional light emitting diodes (LEDs) are built such that the diode's undoped active region, which contains one or more quantum wells, is located between *p*- and *n*-type doped layers. At present, commercially available light emitting diodes based on gallium nitride (GaN) and on alloys of gallium with aluminium (AlGaN) and indium (InGaN) emit light ranging from ultraviolet to green, depending on the composition of the alloy forming the quantum wells in the active region. Information about the structure of standard LEDs based on III group metal nitrides can be found, among others, in "Introduction to Nitride Semiconductor Blue Lasers and Light Emitting Diodes" by S. Nakamura and S. F. Chichibu [ISBN 9780748408368, CRC Press, 2000]. Light emission from a conventional LED is a single peak with the half-width of about a dozen nanometres. In the case of GaN-based diodes, the position of this peak as a function of current changes slightly, that is, by a few nanometres in the direction of the shorter wavelength and this effect is related to the screening of electric fields by the quantum-confined Stark effect (QCSE). Nevertheless, this effect is not strong enough to change the emission colour from red to blue in LEDs with a standard structure.

Devices wherein the colour of the emitted light can be changed within a broad range of the visible light spectrum are most often sets of independently controlled LEDs with strictly defined emission wavelengths. The most basic combination is made by blue (~450 nm), green (~520 nm) and red (~650 nm) colour diodes. By independent control of the light emission power of each of the diodes it is possible to obtain light with any colour, including white light. The level of LED integration can occur at various stages of the engineering process. These can be large LEDs present in the RGB LED strips available on the market or micro-LED arrays. Methods of integration of single micro-LEDs for the purpose of production of multi-colour displays are disclosed in the review publication titled "Full-Color Realization of Micro-LED Displays" by Y. Wu et al. [Nanomaterials 2020, 10, 2482]. Such methods are described there as transfer and bonding of micro-LED chips made of group III metal nitrides and arsenides for dedicated drive substrates in various epitaxial processes, conversion of light from blue colour micro-LEDs to red and green colour with the use of luminophores or quantum dots or monolithic growth of multi-colour LEDs on the same substrate.

Monolithic displays containing diodes with all three primary colours can be made only within the III nitrides, because the band gap of the indium gallium nitride (InGaN) alloy is the only one to cover the whole visible spectrum. The emission wavelength increases in line with the increase in the indium content in the InGaN alloy and in order to achieve the red light emission the indium content in the quantum well alloy should be circa 40%. Such a high indium content in planar structures is difficult to obtain due to high stresses of the InGaN layers and to the demanding conditions for epitaxy. Integration of indium in the micro-LED structure can be controlled at the nanostructure level, which is disclosed in the publication by Ra, Y.-H. et al. titled "Full-Color Single Nanowire Pixels for Projection Displays" [Nano Letters, 2016, 16(7), pp. 4608-4615]. The epitaxy of the InGaN/GaN heterostructure by the PAMBE method, described in said publication, was carried out on a GaN substrate covered with a layer made of titanium, wherein openings with various diameters were left. The epitaxial structure growth occurred only in the openings left in the titanium mask and this way InGaN quantum dots were grown inside nanowires (dot-in-nanowire). Moreover, during the epitaxy of InGaN quantum dots the indium content increased strongly in line with the decrease in the diameter of the nanowires, which resulted in a shift of the emission length in the direction of red colour. This way, by selecting appropriate diameters of the openings in the titanium mask, a multi-colour micro-LED array with four emission colours was made: blue, green, orange and red. But even in this solution a single subpixel structure was still responsible for emitting light with a single colour. It is a disadvantage of the solution wherein three subpixels have different colours that the colour of the light from a single pixel becomes homogeneous for the eye only when observed from an appropriately long distance. This is because when observed from a short distance the component colours of subpixels can be distinguished. In addition, a single maximum for the wavelength that is different from those corresponding to the emissions from single subpixels cannot be achieved in the electroluminescence spectrum. In order to eliminate said disadvantages, such light sources were sought the emission wavelength of which could be changed continuously by changing the power supply voltage or the density of the current flowing through the structure.

Electrically tunable wavelength of emission from a single electroluminescent structure is disclosed in the publication by Y. J. Hong et al. titled "Visible-Color-Tunable Light-Emitting Diodes" [Adv. Mater. 2011, 23, 3284-3288]. These were LEDs made by the MOVPE method, built of a range of nanorods containing multiple InGaN/GaN quantum wells covered with a GaN:Mg layer. InGaN/GaN quantum wells can be distinguished in the structure of a single nanorod, which are located on the side walls, on the slants and on the top of the nanorods with various indium contents, being from 15% on the side walls to 60% on the top of the nanorods. By changing the power supply voltage, the emission wavelength was changed continuously from 690 nm (for 3 V) to 500 nm (for 10 V). This effect was explained by an appropriate model of electric field distribution in the nanorod structure. For the lowest power supply voltage, current with a low density flows preferably through InGaN wells with a high indium content on the top of the nanorods. In line with the increase in the power supply voltage, current with an increasingly higher density flows successively through the quantum wells on the slants and the side walls of the nanorods.

The solution of a LED with an electrically tunable emission wavelength, disclosed in US10418516B2, is closest to the object of the present invention. Said publication relates to planar structures of light emitting diodes, wherein the active region is composed of three different sets of quantum wells with an increasing indium content in the direction from the *n*-type area to the *p*-type area, and these sets of quantum wells are additionally separated by intermediate carrier blocking layers. With an appropriate selection of the composition, width and doping of the carrier blocking layers for low current densities, carriers are injected effectively only to the well with the highest indium content, being 35%, as a result of which red electroluminescence occurs. For higher current densities, the carrier injection effectiveness reaches the maximum successively for multi-quantum wells with the 25% indium content and green electroluminescence and then with the 15% indium content and blue electroluminescence. This way, by controlling the injection of carriers, electrically tunable electroluminescence ranging from 460 nm to 650 nm was obtained. However, red, green and blue light emissions are still achieved from InGaN wells with varied indium contents.

In the aforementioned publications, electroluminescence from diodes based on III nitrides is approached in a traditional manner, wherein the emission wavelength is determined by the indium content in the InGaN alloy forming the quantum well, while there are no publications which would suggest the possibility to obtain an electroluminescent structure wherein the emission wavelength could be changed within a broad range of the visible spectrum, that is, within the wavelength range from 370 nm to 750 nm, from a single and the same quantum well with a relatively low indium content, being for example circa 17%.

### Summary of the invention

The invention is set out in the appended set of claims.

It is an object of the invention to obtain a light emitting diode with a flat structure, enabling light emission within the visible spectrum, that is, with the light wavelength ranging from 370 nm to 750 nm, wherein the emission colour is changed by changing the intensity of the current powering such a diode.

This object is achieved by a diode according to the invention, which has an epitaxial layer structure built of nitrides of group III metals applied to a crystalline substrate. This structure is composed, counted from the crystalline substrate, of at least an *n*-type conductivity layer, a light emitting active region with one quantum well, and a *p*-type conductivity layer. The present invention consists in the active region that is composed, counted from the crystalline substrate, of a lower *n*-type doped barrier layer, a lower *n*-type doped part of the quantum well, an upper *p*-type doped part of the quantum well, and an upper *p*-type doped barrier layer. The width of each part of the quantum well ranges from 4 nm to 25 nm. The doping level of each part of the quantum well ranges from 1 × 10¹⁹ cm⁻³ to 2 × 10²⁰ cm⁻³, while the doping level of the barrier layer is up to 25% of the doping level of the part of the quantum well that is adjacent to said barrier layer.

In one of the variants of the diode according to the invention, each part of the quantum well is made of the InₓGa₁₋ₓN indium gallium nitride alloy, each barrier layer is made of the In_{y}Ga_{1-y}N indium gallium nitride alloy, wherein the indium content in said alloys is determined by the following correlation: 0 ≤ y < x ≤ 0.3.

In another variant of the diode according to the invention, the width of the upper part of the quantum well is between 20% and 80% of the sum of widths of both parts of the quantum well.

In still another variant of the diode according to the invention, between the upper barrier layer and the *p*-type conductivity layer is additionally an electron blocking layer, made of the AlₓGa₁₋ₓN aluminium gallium nitride alloy wherein the aluminium content ranges from 0 to 0.2, wherein the doping level of said layer ranges from 5x 10¹⁸ cm⁻³ to 5 × 10¹⁹ cm⁻³.

The method according to the invention consists in fabricating an epitaxial layer structure on a crystalline substrate, with the structure's containing, counted from the crystalline substrate, at least an *n*-type conductivity layer, a light emitting active region with one quantum well and a *p*-type conductivity layer, of nitrides of group III metals in the process of nitrogen plasma assisted molecular beam epitaxy (PAMBE) growth. The invention is characterised in that an *n*-type conductivity layer, a four-layer active region and a *p*-type conductivity layer are successively fabricated on a crystalline substrate. While fabricating the active region, first its lower *n*-type doped barrier layer is fabricated. Subsequently, a lower *n*-type doped part of the quantum well is fabricated, after which an upper *p*-type doped part of the quantum well is fabricated. The fabrication of the active region is finished by applying an upper *p*-type doped barrier layer. While fabricating both parts of the quantum well, their width ranging from 4 nm to 25 nm and the doping level ranging from 1 × 10¹⁹ cm⁻³ to 2 × 10²⁰ cm⁻³ are applied. While fabricating each barrier layer of the active region, the doping level of up to 25% of the doping level of the part of the quantum well that is adjacent to the barrier layer being fabricated is applied.

In one of the variants of the method according to the invention, each part of the quantum well is made of the InₓGa₁₋ₓN indium gallium nitride alloy, and each barrier layer is made of the In_{y}Ga_{1-y}N indium gallium nitride alloy, by applying the indium content in said alloys that is determined by the following correlation: 0 ≤ y ≤ x ≤ 0.3.

In another variant of the method according to the invention, an upper part of the quantum well is fabricated with the width being between 20% and 80% of the sum of widths of both parts of the quantum well.

In another variant of the method according to the invention, an electron blocking layer is applied additionally between the upper barrier layer and the p-type conductivity layer. For fabrication of said layer, the AlₓGa₁₋ₓN aluminium gallium nitride alloy is used, wherein the aluminium content ranges from 0 to 0.2 and the doping level ranges from 5 × 10¹⁸ cm⁻³ to 5 × 10¹⁹ cm⁻³.

In still another variant of the method according to the invention, the epitaxial growth of the layer structure is performed in metal-rich conditions. Epitaxial layers of said structure are applied at the temperature ranging from 600°C to 800°C, while nitrogen for epitaxial growth of the layer structure is supplied in the form of plasma excited by a power supply unit generating a power between 100 and 600 W, with the nitrogen flow between 1 and 15 cm³ per minute.

The invention breaks the conviction prevailing commonly among specialists that in order to obtain red electroluminescence of a LED fabricated using the technology of nitrides of group III metals, the indium content in the quantum well must be increased to circa 35%. It has turned out unexpectedly that it is possible to obtain lighting from a single quantum well placed in the layer structure of a LED with a much higher wavelength than could be expected from the energy of the band gap of the alloy forming the quantum well, and that the wavelength of emission from such a quantum well can be changed continuously by changing the density of the current flowing through the LED structure. This is possible through an appropriate engineering of the doping of the active region containing one quantum well with the width between 8 nm and 50 nm.

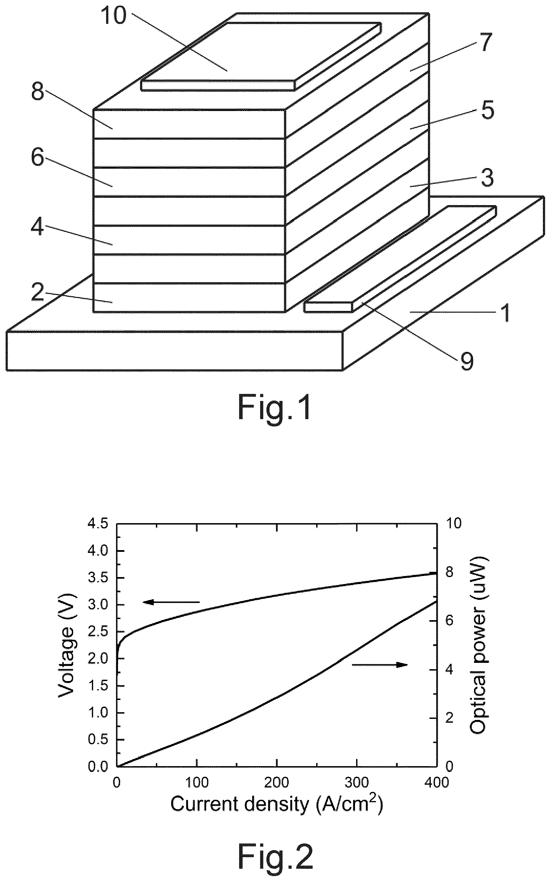

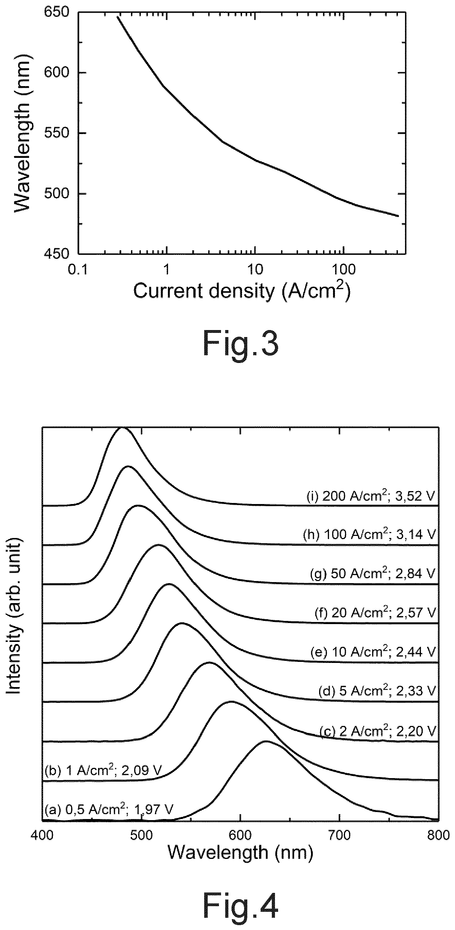

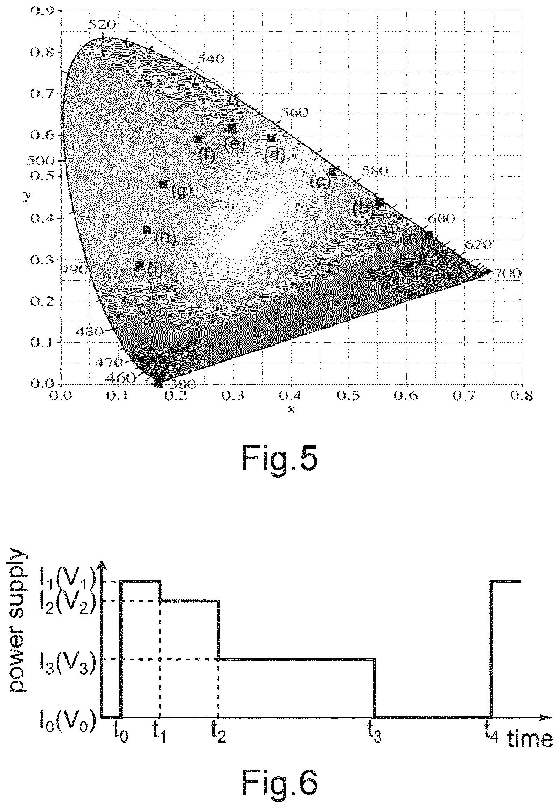

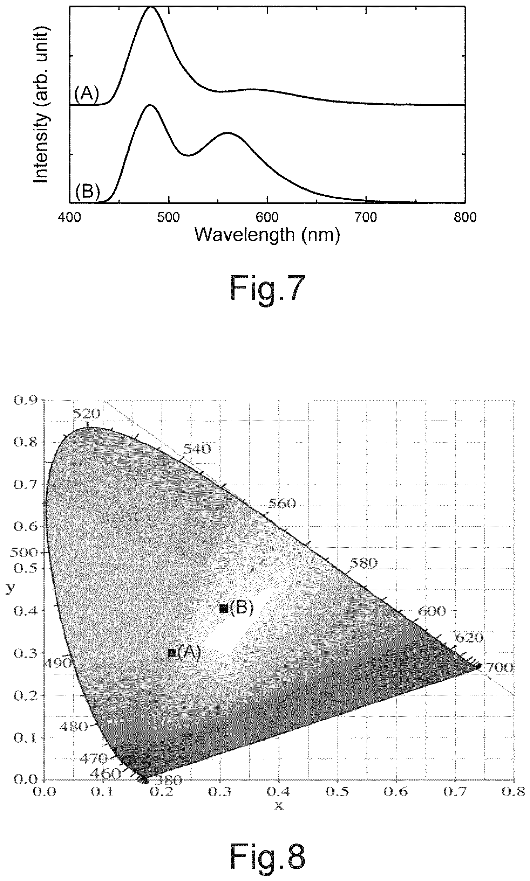

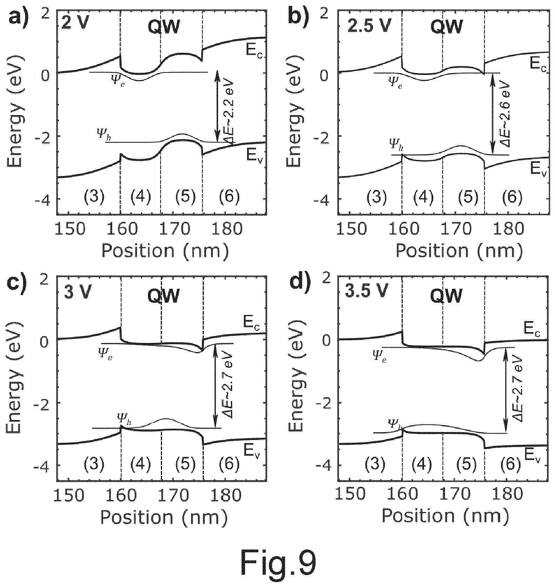

The present invention is reflected in the drawing, with Fig.1 presenting a schematic axonometric view of the diode according to the invention. Fig.2 presents the light-current-voltage (LIV) characteristics of an embodiment of a diode according to the invention, while Fig.3 presents the correlation between the emission wavelength and the density of the current powering said diode. Fig.4 presents standardised spectra of electroluminescence of the same diode for various current densities ranging from 0.5 A/cm² to 200 A/cm², while Fig.5 presents points corresponding to said spectra in a chromaticity diagram according to the CIE 1931 standard. Fig.6 presents an example time diagram of control of the power supply of the diode according to the invention. Fig.7 presents spectra of white light obtained by mixing blue and yellow light by the method according to the diagram in Fig.6, while Fig.8 presents points corresponding to said spectra in a chromaticity diagram according to the CIE 1931 standard. Fig.9 presents diagrams of the band structures of the active region, which reflect the scheme of operation of a diode according to the invention for four different voltages powering said diode.

The present invention is presented in more detail in the embodiment described below. Fig.1 shows that the embodiment of a diode according to the invention contains a set of epitaxial layers, which is composed successively, counted from the crystalline substrate 1, of an *n*-type conductivity layer 2, an active region (layers from 3 through 6), an electron blocking layer 7 and a *p*-type conductivity layer 8. The aforementioned active region is composed of four successive layers: a lower *n*-type doped barrier layer 3, a lower *n*-type doped part 4 of the quantum well, an upper *p*-type doped part 5 of the quantum well, and an upper *p*-type doped barrier layer 6. Such a diode contains a first current terminal 9, connected electrically with the lower *n*-type conductivity layer 2, and a second current terminal 10, connected electrically with the *p*-type conductivity layer 8.

This diode was fabricated in the process of nitrogen plasma assisted molecular beam epitaxy (PAMBE) growth in a Veeco GEN-20 reactor. The substrate 1 with the thickness of 350 µm, made of gallium nitride, was heated in a prechamber of said reactor at the temperature of 150°C for 90 minutes. The heating of the substrate 1 was continued for 30 minutes in a preparatory chamber at the temperature of 650°C. The heated substrate 1 was transferred to a growth chamber. The layer epitaxy was performed in metal-rich conditions. Nitrogen in the form of plasma excited by radio frequencies by a power supply unit was used for the growth, wherein the plasma parameters varied depending on the currently grown layer. For the GaN layers, nitrogen flow was set at 2.2 cm³/min and the power supply unit's power was set at 250 W. For the InGaN layers, said parameters were 10 cm³/min and 340 W, respectively. The growth of the GaN layers was performed at the temperature of 730°C, while of the InGaN layers - at the temperature of 650°C. Metals forming the alloys, such as gallium, indium and aluminium, and *n*-type dopant materials, that is, silicon and germanium, were evaporated from standard Knudsen cells, while as a source of *p*-type magnesium dopant a special structure of the Knudsen cell was used, which had an additional valve inside the cell, which valve allows a faster adjustment of the magnesium dopant atom flux size during the growth. The purity of the elements used for the epitaxy exceeded 99.999%. Firstly, on the substrate 1 a layer 2 (*n*-type) with the thickness of 100 nm was fabricated of GaN, with the silicon doping level of 1 × 10¹⁸ cm⁻³. Subsequently, an active region (3, 4, 5, 6) was fabricated, which at the bottom contained a lower barrier layer 3 with the thickness of 60 nm, made of the silicon-doped In_{0.02}Ga_{0.98}N alloy with the doping level of 4 × 10¹⁸ cm⁻³. Another layer of said region was a lower part of the quantum well 4 with the thickness of 7.8 nm, made of the germanium-doped In_{0.17}Ga_{0.83}N alloy with the doping level of 6 × 10¹⁹ cm⁻³. The next layer of the active region was an upper part of the quantum well 5 with the thickness of 7.8 nm, made of the magnesium-doped In_{0.17}Ga_{0.83}N alloy with the doping level of 6 × 10¹⁹ cm⁻³. The last layer of the active region was an upper barrier layer 6 with the thickness of 60 nm, made of the magnesium-doped In_{0.02}Ga_{0.98}N alloy with the doping level of 4 × 10¹⁸ cm⁻³. On the finished active region, an electron blocking layer 7 with the thickness of 20 nm, made of magnesium-doped GaN with the doping level of 2 × 10¹⁹ cm⁻³, was fabricated. As the last one, a p-type conductivity layer 8 was fabricated, composed of a first sublayer with the thickness of 100 nm, made of magnesium-doped gallium nitride with the doping level of 1 × 10¹⁸ cm⁻³, of a second sublayer with the thickness of 40 nm, made of the magnesium-doped In_{0.02}Ga_{0.98}N alloy with the doping level of 6 × 10¹⁹ cm⁻³, and of a third sublayer with the thickness of 5 nm, made of the magnesium-doped In_{0.17}Ga_{0.83}N alloy with the doping level of 2 × 10²⁰ cm⁻³. On the top of the epitaxial structure fabricated by the aforementioned method, metallisation composed of a sequence of Ni/Au with the thickness of 2.5/7.5 nm was applied and subjected to the heating process in the nitrogen and oxygen atmosphere for one minute at the temperature of 500°C. Subsequently, said structure was subjected to photolithography and reactive ion etching to form mesas with the dimensions of 350 × 350 µm and 100 × 100 µm, which were etched 400 nm deep, that is, to the level of the *n*-type conductivity layer 2. On the top of the fabricated mesas, next Ni/Au/Pt metallisation with the thickness of 25/75/60 nm was applied in the form of grids with the dimensions of 340 × 340 µm on the mesas with the dimensions of 350 × 350 µm and in the form of solid squares with the dimensions of 90 × 90 µm on the mesas with the dimensions of 100 × 100 µm, composing the second (upper) current terminal 10. Subsequently, the metallisations were heated again in the nitrogen and oxygen atmosphere for ten minutes at the temperature of 500°C. At the last stage, metallisation of Ti/Al/Ni/ Au with the thickness of 30/60/40/75 nm, composing the first (lower) current terminal 9, was applied on the side of the mesas.

The electrooptical properties of the fabricated structure were measured by the needle method, wherein a power supply unit and a voltage meter were interfaced with a spectrometer and an optical power meter. The optical power meter was placed at a constant height above the sample surface but it did not collect the whole light emitted from the sample to the outside, hence the optical powers presented in the chart (Fig.2) are purely qualitative. As reflected in Fig.2, the embodiment of a diode with the mesa size of 350 × 350 µm has current-voltage (I-V) characteristics in the forward direction that is typical of a LED, but the diode opening voltage is relatively low: circa 2.2 V. Optical power emitted from said diode increases approximately in a linear manner as a function of current density. Fig.3 presents a semi-log plot with the change in the wavelength of the light emitted from the embodiment of a diode as a function of current density. The spectrum maximum shifts towards the shorter waves within the range from 645 nm to 481 nm in line with the increase in the density of the current flowing through the diode within the range from 0.3 A/cm² to 400 A/cm². Fig.4 presents standardised electroluminescence spectra for nine selected current densities, designated with letters from (a) through (i) in the drawing. In Fig.5, the same spectra (for the same current densities as in Fig.4) are presented in the chromaticity diagram of the CIE1931 colour space. As reflected in Fig.2 through Fig.5, the colour of the light emitted from the diode according to the invention can be continuously changed within the whole visible spectrum, that is, from the red, to orange, yellow, green, cyan to blue, by changing the density of the current flowing through the diode, which is equivalent to a change in the voltage powering the diode.

Through appropriate power supply of the diode according to the invention, it is possible to control its power and mix the colours emitted by said diode in order to form white light and other colours in the CIE 1931 space.

A scheme of such a power supply is presented in Fig.6. The current (I) or voltage (V) powering the diode changes stepwise. By selecting a power supply level, the wavelength of one of the peaks in the final spectrum is changed, and its intensity is adjusted by the duration. This way it is possible to set, for example, four power supply levels, with three responsible for emission of light of an appropriate primary colour: blue I₁(V₁), green I₂(V₂) and red I₃(V₃), and the zero level I₀(V₀), for which no emission occurs. The final lighting power can be reduced by prolonging the duration of the zero level.

Fig.7 presents two spectra (A) and (B) of white light, obtained with the use of the power supply scheme described above, which uses two different power supply levels (V₁ and V₂) for the embodiment of a diode according to the invention with the dimensions of 100 × 100 µm. In Fig.8, the same spectra as in Fig.7 are presented in the chromaticity diagram of the CIE 1931 colour space. Such a waveform of the power supply was achieved with the use of a programmable arbitrary power supply unit, Siglent SDG2042X. In the case of the spectrum designated with (A), cold white light was achieved when the diode was powered with voltages V₁ = 3.5 V and V₂ = 2.1 V, while the time of powering with voltage V₂ (for example, from t₁ to t₂ in Fig.6) was 2046 times longer than the time of its powering with voltage V₁ (for example, from to to t₁ in Fig.6). In the case of the spectrum designated with (B), in turn, warm white light was achieved when the diode was powered with voltages V₁ = 3.7 V and V₂ = 2.22 V, while the time of powering with voltage V₂ was 2046 times longer than the time of its powering with voltage V₁. In both cases, voltage levels changed cyclically with the frequency of 1 kHz, which means that the aggregate duration of both power supply voltages in one cycle was 0.001 s.

Fig.9 presents four band diagrams as a function of distance from crystalline substrate, prepared for four different voltages applied to the diode according to the invention, which illustrate the method of operation of such a diode. Diagram a) refers to the voltage of 2 V, while diagram b) - to the voltage of 2.5 V. As shown in the aforementioned diagrams, conduction and valence bands inside quantum wells are bent because of the strong doping of the individual parts of quantum wells. In this regard, the energy difference between the energy levels of the wave functions for holes and electrons changes in line with the increase in the voltage powering the diode from 2.2 eV to 2.6 eV. This effect is responsible for the change in the colour of the emission from the diode. Diagrams c) and d) prepared for higher voltages, that is, 3 V and 3.5 V, respectively, show that a quantum well is then virtually flat and resembles a case of an undoped well, wherein the energy difference between the energy levels of the wave functions for holes and electrons does not change and the electroluminescence wavelength is defined by the indium content in the quantum well.

## Claims

1. A light emitting diode with a variable light emission colour, having an epitaxial layer structure built of nitrides of group III metals applied to a crystalline substrate, which structure is composed, counted from the crystalline substrate, of at least an *n*-type conductivity layer, a light emitting active region with one quantum well, and a *p*-type conductivity layer, **characterised in that** the active region (3, 4, 5, 6) is composed, counted from the crystalline substrate (1), of a lower *n*-type doped barrier layer (3), a lower *n*-type doped part (4) of the quantum well, an upper *p*-type doped part (5) of the quantum well, and an upper *p*-type doped barrier layer (6), wherein the width of each part (4, 5) of the quantum well ranges from 4 nm to 25 nm, the doping level of each part (4, 5) of the quantum well ranges from 1 × 10¹⁹ cm⁻³ to 2 × 10²⁰ cm⁻³, while the doping level of the barrier layer (3, 6) is up to 25% of the doping level of the part of the quantum well (4, 5) that is adjacent to said barrier layer (3, 6).

2. The diode according to claim 1, **characterised in that** each part (4, 5) of the quantum well is made of the InₓGa₁₋ₓN indium gallium nitride alloy, each barrier layer (3, 6) is made of the In_{y}Ga_{1-y}N indium gallium nitride alloy, wherein the indium content in said alloys is determined by the following correlation: 0 ≤ y < x ≤ 0.3.

3. The diode according to claim 1 or 2, **characterised in that** the width of the upper part (5) of the quantum well is between 20% and 80% of the sum of widths of both parts (4, 5) of the quantum well.

4. The diode according to claim 1 or 2 or 3, **characterised in that** between the upper barrier layer (6) and the *p*-type conductivity layer (8) is additionally an electron blocking layer (7), made of the AlₓGa₁₋ₓN aluminium gallium nitride alloy wherein the aluminium content ranges from 0 to 0.2, wherein the doping level of said layer (7) ranges from 5 × 10¹⁸ cm⁻³ to 5 × 10¹⁹ cm⁻³.

5. A method of fabrication of a light emitting diode with a variable light emission colour, consisting in fabricating an epitaxial layer structure on a crystalline substrate, with the structure's containing, counted from the crystalline substrate, at least an *n*-type conductivity layer, a light emitting active region with one quantum well and a *p*-type conductivity layer, of nitrides of group III metals in the process of nitrogen plasma assisted molecular beam epitaxy (PAMBE) growth, **characterised in that** an *n*-type conductivity layer (2), a four-layer active region (3, 4, 5, 6) and a *p*-type conductivity layer (8) are successively fabricated on a crystalline substrate (1), wherein, while fabricating the active region (3, 4, 5, 6), first its lower *n*-type doped barrier layer (3) is fabricated, subsequently, a lower *n*-type doped part (4) of the quantum well is fabricated, after which an upper *p*-type doped part (5) of the quantum well is fabricated, and finally an upper *p*-type doped barrier layer (6) is fabricated, wherein, while fabricating each part (4, 5) of the quantum well, their width ranging from 4 nm to 25 nm and the doping level ranging from 1 × 10¹⁹ cm⁻³ to 2 × 10²⁰ cm⁻³ are applied, and while fabricating each barrier layer (3, 6) of the active region, the doping level of up to 25% of the doping level of the part (4, 5) of the quantum well that is adjacent to the barrier layer (3, 6) being fabricated is applied.

6. The method according to claim 5, **characterised in that** each part (4, 5) of the quantum well is made of the InₓGa₁₋ₓN indium gallium nitride alloy, and each barrier layer (3, 6) is made of the In_{y}Ga_{1-y}N indium gallium nitride alloy, by applying the indium content in said alloys that is determined by the following correlation: 0 ≤ y < x ≤ 0.3.

7. The method according to claim 5 or 6, **characterised in that** in the process of growth of the active region (3, 4, 5, 6) an upper part (5) of the quantum well is fabricated with the width being between 20% and 80% of the sum of widths of both parts (4, 5) of the quantum well.

8. The method according to claim 5 or 6 or 7, **characterised in that** an electron blocking layer (7) is applied additionally between the upper barrier layer (6) and the *p*-type conductivity layer (8), and for fabrication of said layer, the AlₓGa₁₋ₓN aluminium gallium nitride alloy is used, wherein the aluminium content ranges from 0 to 0.2 and the doping level of said layer (7) ranges from 5 × 10¹⁸ cm⁻³ to 5 × 10¹⁹ cm⁻³.

9. The method according to claim 5 or 6 or 7 or 8, **characterised in that** the epitaxial growth of the layer structure is performed in metal-rich conditions, the epitaxial layers (2 through 8) are applied at the temperature ranging from 600°C to 800°C, while nitrogen for epitaxial growth of the layer structure is supplied in the form of plasma excited by a power supply unit generating a power between 100 and 600 W, with the nitrogen flow between 1 and 15 cm³ per minute.

## Patentansprüche

1. Lichtemittierende Diode mit einer variablen Lichtemissionsfarbe, die eine epitaktische Schichtstruktur aufweist, die aus Nitriden von Metallen der Gruppe III aufgebaut ist, die auf ein kristallines Substrat aufgebracht sind, wobei die Struktur, vom kristallinen Substrat aus gerechnet, aus mindestens einer *n*-Typ-Leitfähigkeitsschicht, einem lichtemittierenden aktiven Bereich mit einem Quantentopf und einer *p*-Typ-Leitfähigkeitsschicht zusammengesetzt ist, **dadurch gekennzeichnet, dass** der aktive Bereich (3, 4, 5, 6), vom kristallinen Substrat (1) aus gerechnet, aus einer unteren *n-*Typ-dotierten Sperrschicht (3), einem unteren n-dotierten Teil (4) des Quantentopfs, einem oberen *p-*dotierten Teil (5) des Quantentopfs und einer oberen p-dotierten Sperrschicht (6) besteht, wobei die Breite jedes Teils (4, 5) des Quantentopfs im Bereich von 4 nm bis 25 nm liegt, das Dotierungsniveau jedes Teils (4, 5) des Quantentopfes im Bereich von 1 × 10¹⁹ cm⁻³ bis 2 × 10²⁰ cm⁻³ liegt, während das Dotierungsniveau der Sperrschicht (3, 6) bis zu 25% des Dotierungsniveaus des Teils des Quantentopfes (4, 5) beträgt, der an die Sperrschicht (3, 6) angrenzt.

2. Die Diode nach Anspruch 1, **dadurch gekennzeichnet, dass** jeder Teil (4, 5) des Quantentopfes aus der Indium-Gallium-Nitrid-Legierung InₓGa₁₋ₓN hergestellt ist, jede Sperrschicht (3, 6) aus der Indium-Gallium-Nitrid-Legierung In_{y}Ga_{1-y}N hergestellt ist, wobei der Indiumgehalt in den Legierungen durch die folgende Korrelation bestimmt ist: 0≤y <X≤0,3.

3. Die Diode nach Anspruch 1 oder 2, **dadurch gekennzeichnet, dass** die Breite des oberen Teils (5) des Quantentopfes zwischen 20% und 80% der Summe der Breiten der beiden Teile (4, 5) des Quantentopfes beträgt.

4. Die Diode nach Anspruch 1 oder 2 oder 3, **dadurch gekennzeichnet, dass** sich zwischen der oberen Sperrschicht (6) und der p-Leitfähigkeitsschicht (8) zusätzlich eine Elektronensperrschicht (7) aus der Aluminium-Galliumnitrid-Legierung AlₓGa₁₋ₓN befindet, wobei der Aluminiumgehalt zwischen 0 und 0,2 liegt, wobei das Dotierungsniveau der Schicht (7) zwischen 5 × 10¹⁸ cm⁻³ to 5 × 10¹⁹ cm⁻³ liegt.

5. Ein Verfahren zur Herstellung einer lichtemittierenden Diode mit einer variablen Lichtemissionsfarbe, das darin besteht, eine epitaktische Schichtstruktur auf einem kristallinen Substrat herzustellen, wobei die Struktur, vom kristallinen Substrat aus gerechnet, mindestens eine *n-*Typ-Leitfähigkeitsschicht, einen lichtemittierenden aktiven Bereich mit einem Quantentopf und eine *p-*Typ-Leitfähigkeitsschicht enthält, von Nitriden aus Metallen der Gruppe III im Verfahren des Stickstoff Plasma-unterstützten Molekularstrahl-Epitaxie (PAMBE)-Wachstums, **dadurch gekennzeichnet, dass** eine *n*-Typ-Leitfähigkeitsschicht (2), ein vierschichtiger aktiver Bereich (3, 4, 5, 6) und eine *p-*Typ-Leitfähigkeitsschicht (8) nacheinander auf einem kristallinen Substrat (1) hergestellt werden, wobei bei der Herstellung des aktiven Bereichs (3, 4, 5, 6) zunächst seine untere *n*-dotierte Barriereschicht (3) hergestellt wird, anschließend ein unterer *n*-dotierter Teil (4) des Quantentopfs hergestellt wird, danach ein oberer *p*-dotierter Teil (5) des Quantentopfs hergestellt wird und schließlich eine obere *p*-dotierte Barriereschicht (6) hergestellt wird, wobei bei der Herstellung jedes Teils (4, 5) des Quantentopfs, ihre Breite im Bereich von 4 nm bis 25 nm und das Dotierungsniveau im Bereich von 1 × 10¹⁹ cm⁻³ to 2 × 10²⁰ cm⁻³ angewandt werden, und während der Herstellung jeder Barriereschicht (3, 6) des aktiven Bereichs das Dotierungsniveau von bis zu 25% des Dotierungsniveaus des Teils (4, 5) des Quantentopfs, der an die herzustellende Barriereschicht (3, 6) angrenzt, angewandt wird.

6. Das Verfahren nach Anspruch 5, **dadurch gekennzeichnet, dass** jeder Teil (4, 5) des Quantentopfes aus der Indium-Gallium-Nitrid-Legierung InₓGa₁-ₓN hergestellt ist, und jede Sperrschicht (3, 6) aus der Indium-Gallium-Nitrid-Legierung In_{y}Ga_{1-y}N hergestellt ist, durch Anwendung des Indiumgehalts in diesen Legierungen, der durch die folgende Korrelation bestimmt wird: 0≤y<x≤0,3.

7. Das Verfahren nach Anspruch 5 oder 6, **dadurch gekennzeichnet, dass** beim Wachstumsprozess des aktiven Bereichs (3, 4, 5, 6) ein oberer Teil (5) des Quantentopfs mit einer Breite zwischen 20% und 80% der Summe der Breiten der beiden Teile (4, 5) des Quantentopfs hergestellt wird.

8. Das Verfahren nach Anspruch 5 oder 6 oder 7, **dadurch gekennzeichnet, dass** zwischen der oberen Barriereschicht (6) und der *p*-Typ-Leitfähigkeitsschicht (8) zusätzlich eine Elektronensperrschicht (7) aufgebracht wird und für die Herstellung dieser Schicht die Aluminium-Gallium-Nitrid-Legierung AlₓGa₁₋ₓN verwendet wird, wobei der Aluminiumgehalt im Bereich von 0 bis 0,2 liegt und das Dotierungsniveau der Schicht (7) im Bereich von 5×10¹⁸ cm⁻³ to 5x 10¹⁹cm⁻³ liegt.

9. Das Verfahren nach Anspruch 5 oder 6 oder 7 oder 8, **dadurch gekennzeichnet, dass** das epitaktische Wachstum der Schichtstruktur unter metallreichen Bedingungen durchgeführt wird, die epitaktischen Schichten (2 bis 8) bei einer Temperatur im Bereich von 600°C bis 800°C aufgebracht werden, während Stickstoff für das epitaktische Wachstum der Schichtstruktur in Form eines Plasmas zugeführt wird, das durch eine Stromversorgungseinheit angeregt wird, die eine Leistung zwischen 100 und 600 W erzeugt, wobei der Stickstofffluss zwischen 1 und 15 cm³ pro Minute liegt.

## Revendications

1. Une diode électroluminescente à couleur d'émission lumineuse variable, ayant une structure de couche épitaxiale constituée de nitrures de métaux du groupe III appliquée à un substrat cristallin, cette structure étant composée, à partir du substrat cristallin, d'au moins une couche de conductivité de type n, d'une région active électroluminescente avec un puits quantique, et d'une couche de conductivité de type **p-,caractérisée en ce que** la région active (3, 4, 5, 6) est composée, à partir du substrat cristallin (1), d'une couche barrière dopée de type *n* inférieur (3), d'une partie dopée de type n inférieur (4) du puits quantique, d'une partie dopée de type *p* supérieur (5) du puits quantique et d'une couche barrière dopée de type *p* supérieur (6), dans laquelle la largeur de chaque partie (4, 5) du puits quantique est comprise entre 4 nm et 25 nm, le niveau de dopage de chaque partie (4, 5) du puits quantique est compris entre 1 × 10¹⁹ cm⁻³ et 2 × 10²⁰ cm⁻³, tandis que le niveau de dopage de la couche barrière (3, 6) représente jusqu'à 25 % du niveau de dopage de la partie du puits quantique (4, 5) qui est adjacente à ladite couche barrière (3, 6).

2. La diode selon la revendication 1, **caractérisée en ce que** chaque partie (4, 5) du puits quantique est constituée de l'alliage de nitrure de gallium d'indium InₓGa₁₋ₓN, chaque couche barrière (3, 6) est constituée de l'alliage de nitrure de gallium d'indium In_{y}Ga_{1-y}N, où la teneur en indium dans lesdits alliages est déterminée par la corrélation suivante : 0≤y <x≤0,3.

3. La diode selon la revendication 1 ou 2, **caractérisée en ce que** la largeur de la partie supérieure (5) du puits quantique est comprise entre 20 % et 80 % de la somme des largeurs des deux parties (4, 5) du puits quantique.

4. La diode selon la revendication 1 ou 2, ou 3, **caractérisée en ce qu'**entre la couche barrière supérieure (6) et la couche conductrice de type *p* (8) se trouve en outre une couche de blocage d'électrons (7), constituée d'un alliage de nitrure de gallium d'aluminium AlₓGa₁-ₓN, dans laquelle la teneur en aluminium est comprise entre 0 et 0,2, et dans laquelle le niveau de dopage de ladite couche (7) est compris entre 5 × 10¹⁸ cm⁻³ et 5 × 10¹⁹ cm⁻³.

5. Un procédé de fabrication d'une diode électroluminescente à couleur d'émission lumineuse variable, consistant à fabriquer une structure de couche épitaxiale sur un substrat cristallin, la structure contenant, à partir du substrat cristallin, au moins une couche de conductivité de type n, une région active électroluminescente avec un puits quantique et une couche de conductivité de type *p*, de nitrures de métaux du groupe III dans le processus de croissance par épitaxie par faisceaux moléculaires assistée par plasma d'azote (PAMBE), **caractérisé en ce qu'**une couche conductrice de type n (2), une région active à quatre couches (3, 4, 5, 6) et une couche conductrice de type *p* (8) sont fabriquées successivement sur un substrat cristallin (1), dans lequel, lors de la fabrication de la région active (3, 4, 5, 6), premièrement sa couche barrière dopée de type *n* inférieure (3) est fabriquée, ensuite une partie dopée de type *n* inférieure (4) du puits quantique est fabriquée, après quoi une partie dopée de type *p* supérieure (5) du puits quantique est fabriquée, et enfin une couche barrière dopée de type *p* supérieure (6) est fabriquée, dans lequel, lors de la fabrication de chaque partie (4, 5) du puits quantique, leur largeur allant de 4 nm à 25 nm et le niveau de dopage allant de 1 × 10¹⁹ cm⁻³ à 2 × 10²⁰ cm⁻³ sont appliqués, et lors de la fabrication de chaque couche barrière (3, 6) de la région active, le niveau de dopage allant jusqu'à 25 % du niveau de dopage de la partie (4, 5) du puits quantique qui est adjacente à la couche barrière (3, 6) étant fabriquée, est appliqué.

6. Le procédé selon la revendication 5, **caractérisé en ce que** chaque partie (4, 5) du puits quantique est constituée de l'alliage de nitrure de gallium d'indium InₓGa₁-ₓN, et chaque couche barrière (3, 6) est constituée de l'alliage de nitrure de gallium d'indium In_{y}Ga₁-_{y}N, en appliquant la teneur en indium dans lesdits alliages qui est déterminée par la corrélation suivante : 0≤y<X≤0,3.

7. Le procédé selon la revendication 5 ou 6, **caractérisé en ce que** dans le processus de croissance de la région active (3, 4, 5, 6), une partie supérieure (5) du puits quantique est fabriquée avec une largeur comprise entre 20 % et 80 % de la somme des largeurs des deux parties (4, 5) du puits quantique.

8. Le procédé selon la revendication 5 ou 6, ou 7, **caractérisé en ce qu'**une couche de blocage d'électrons (7) est appliquée en outre entre la couche barrière supérieure (6) et la couche de conductivité de type p (8), et pour la fabrication de cette couche, l'alliage de nitrure de gallium d'aluminium AlₓGa₁₋ₓN est utilisé, dans lequel la teneur en aluminium est comprise entre 0 et 0,2 et le niveau de dopage de cette couche (7) est compris entre 5×10¹⁸ cm⁻³ et 5x 10¹⁹cm⁻³.

9. Le procédé selon la revendication 5 ou 6, ou 7, ou 8, **caractérisé en ce que** la croissance épitaxiale de la structure en couches est réalisée dans des conditions riches en métaux, les couches épitaxiales (2 à 8) sont appliquées à une température comprise entre 600°C et 800°C, tandis que l'azote nécessaire à la croissance épitaxiale de la structure en couches est fourni sous forme de plasma excité par une unité d'alimentation générant une puissance comprise entre 100 et 600 W, avec un débit d'azote compris entre 1 et 15 cm³ par minute.
